Europäisches Patentamt

European Patent Office

Office européen des brevets

(19)

(11) Veröffentlichungsnummer: **0 450 163 A1**

# (12) EUROPÄISCHE PATENTANMELDUNG

(21) Anmeldenummer: 90123512.7

(22) Anmeldetag: 07.12.90

(51) Int. Cl.⁵: **C23C 14/35, H01J 37/34**

(30) Priorität: 31.03.90 DE 4010495

(43) Veröffentlichungstag der Anmeldung:
09.10.91 Patentblatt 91/41

(84) Benannte Vertragsstaaten:
CH DE ES FR IT LI

(71) Anmelder: **LEYBOLD AKTIENGESELLSCHAFT**
**Wilhelm-Rohn-Strasse 25**
**W-6450 Hanau am Main 1(DE)**

(72) Erfinder: **Stang, Wolfgang, Dipl.-Ing.**
**Erlenweg 11**
**W-6471 Kefenrod(DE)**

(54) **Vorrichtung zum Beschichten eines Substrats mit Werkstoffen, beispielsweise mit Metallen.**

(57) Bei einer Vorrichtung zum Beschichten eines Substrats (1) mit Werkstoffen, mit Hilfe von Stromquellen (10, 10a), welche jeweils mit einer in einer evakuierbaren Beschichtungskammer (15a) angeordneten Elektroden (5 bzw. 5a) verbunden sind, die jeweils elektrisch mit einem Target (3, 3a) in Verbindung stehen, das zerstäubt wird und dessen zerstäubte Teilchen sich auf dem Substrat (1) niederschlagen, wozu in die Beschichtungskammer (15, 15a) ein Prozeßgas einbringbar ist, sind zur Verbesserung der Schicht (2) auf dem Substrat (1) die einzelnen Targets (3, 3a) in einem Winkel (α, α') zur Ebene des Substrats (1) gehalten, so daß sich über Längsachsen (l, l') bzw. die Hauptwanderungsrichtungen des Beschichtungsmaterials im Punkt (S) schneiden.

Die Erfindung betrifft eine Vorrichtung zum Beschichten eines Substrats mit Werkstoffen, beispielsweise mit Metallen, bestehend aus einer oder mehreren Stromquellen, welche mit in einer evakuierbaren Beschichtungskammer angeordneten Elektroden verbunden sind, die elektrisch mit Targets in Verbindung stehen, die zerstäubt werden und deren zerstäubte Teilchen sich auf dem Substrat niederschlagen, wobei in die Beschichtungskammer ein Prozeßgas einbringbar ist.

Bekannt sind Kathodenzerstäubungsvorrichtungen mit mehreren Targets, die nebeneinanderliegend angeordnet sind und aus verschiedenen zu zerstäubenden Werkstoffen gebildet sind (DE-OS 26 36 293, DE-OS 29 32 483; DD-PS 111 409, DE-OS 1 790 178).

Der vorliegenden Erfindung liegt die Aufgabe zugrunde, eine Vorrichtung zu schaffen, die geeignet ist, die Qualität von aufgesputterten Schichten wesentlich zu verbessern, ohne daß herkömmliche bzw. bereits vorhandene Vorrichtungen oder Anlagen dafür ungeeignet sind bzw. ohne daß an diesen wesentliche oder kostspielige Umbauten oder Änderungen vorgenommen werden müssen.

Diese Aufgabe wird erfindungsgemäß dadurch gelöst, daß die Targets aus einem oder mehreren zu zerstäubenden Werkstoffen jeweils in einem Winkel zur Ebene des Substrats gehalten sind, wobei sich die Hauptwanderungsrichtungen der Teilchenströme der auf das Substrat ausgerichteten Targets schneiden.

Weitere Merkmale und Einzelheiten sind in den Ansprüchen näher beschrieben und gekennzeichnet.

Die Erfindung läßt die verschiedensten Ausführungsmöglichkeiten zu; eine davon ist in der anhängenden Zeichnung schematisch näher dargestellt, die eine Sputteranlage mit zwei Targets für das DC-Sputtern zeigt.

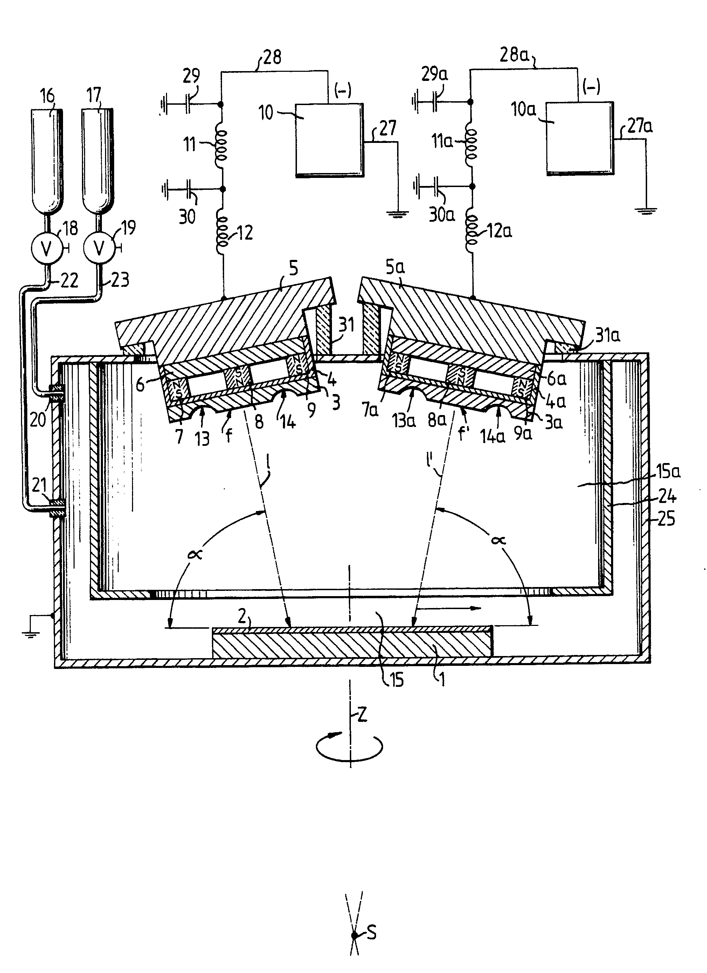

In der Zeichnung ist ein Substrat 1 dargestellt, das mit einer dünnen Schicht 2 versehen werden soll. Diesem Substrat 1 liegen zwei Targets 3, 3a gegenüber, die zu zerstäuben sind. Die Targets 3, 3a stehen jeweils über ein im Schnitt U-förmiges Element 4, 4a mit jeweils einer Elektrode 5, 5a in Verbindung, die jeweils auf einem Joch 6, 6a ruhr, welches zwischen sich und dem Element 4, 4a jeweils drei Dauermagnete 7, 8, 9 bzw. 7a, 8a, 9a einschließt. Die jeweils auf die Targets 3, 3a gerichteten Polaritäten der Pole der drei Dauermagnete 7, 8, 9 bzw. 7a, 8a, 9a wechseln sich ab so daß jeweils die Südpole der beiden jeweils äußeren Dauermagnete 7, 9 bzw. 7a, 9a mit dem Nordpol des jeweils mittleren Dauermagneten 8 bzw. 8a jeweils ein etwa kreisbogenförmiges Magnetfeld durch das Target 3 bzw. 3a bewirken. Dieses Magnetfeld verdichtet jeweils das Plasma vor dem Target 3 bzw. 3a, so daß es dort, wo die Magnetfelder das Maximum ihres Kreisbogens besitzen, seine größte Dichte hat. Die Ionen im Plasma werden durch elektrische Felder beschleunigt, die sich aufgrund einer Gleichspannung aufbauen, die von Gleichstromquellen 10, 10a angegeben wird. Diese Gleichstromquellen 10, 10a sind jeweils mit ihren negativen Polen über zwei Induktivitäten 11, 12 bzw. 11a, 12a mit der Elektrode 5 bzw. 5a verbunden. Das elektrische Feld steht jeweils senkrecht auf der Oberfläche des zugeordneten Targets 3 bzw. 3a und beschleunigt die positiven Ionen des Plasmas in Richtung auf dieses Target. Hierdurch werden mehr oder weniger viele Atome oder Partikel aus dem Target 3 bzw. 3a herausgeschlagen, und zwar insbesondere aus den Gebieten 13, 14 bzw. 13a, 14a, wo die Magnetfelder ihre Maxima haben. Die zerstäubten Atome oder Partikel wandern in Richtung auf das Substrat 1, wo sie sich als dünne Schicht 2 niederschlagen und zwar in Richtung der strichliert eingezeichneten Achsen bzw. Pfeile I, I'.

Für die Steuerung der dargestellten Anordnung kann ein Prozeßrechner vorgesehen werden, der Meßdaten verarbeitet und Steuerungsbefehle abgibt. Diesem Prozeßrechner können beispielsweise die Werte des gemessenen Partialdrucks in der Prozeßkammer 15 zugeführt werden. Aufgrund dieser und anderer Daten kann er zum Beispiel den Gasfluß über die Ventile 18, 19 regeln und die Spannung an den Kathoden 5, 5a einstellen. Der Prozeßrechner ist auch in der Lage, alle anderen Variablen, zum Beispiel Kathodenstrom und magnetische Feldstärke zu regeln. Da derartige Prozeßrechner bekannt sind, wird auf eine Beschreibung ihres Aufbaus verzichtet.

Die einzelnen Targets 3, 3a bzw. deren Elektroden 5, 5a sind auf ringförmigen Halteteilen oder Haltekragen 31, 31a gelagert, so daß sich ihre ebenen Targetflächen f, f' in einer gekippten Position zur Ebene des Substrats 1 befinden. Diese Haltekragen 31, 31a sind zylindrische Ringe, deren jeweils eine Stirnfläche eine schiefe Ebene bildet (d. h. deren obere Stirnfläche schief zur Längsachse des jeweiligen zylindrischen Ringes verläuft). Der Strom der abzusputternden Teilchen bzw. die Symmetrieachse der Sputterwolke in Richtung auf das Substrat ist in der Zeichnung jeweils mit I bzw. I' bezeichnet.

Es ist klar, daß abweichend von der dargestellten Vorrichtung auch mehr als zwei Targets 3, 3a vorgesehen sein können, deren Achsen I, I', ... sich sämtlich in einem Punkte S schneiden. Ebenso ist es ohne weiteres möglich, das Substrat 1 rotierbar vorzusehen (z. B. um die Achse Z).

Durch bloßen Austausch der Kragenteile bzw. der Ringe 31, 31a läßt sich der Schnittpunkt S verschieben bzw. lassen sich die Winkel α, α', ... den Sputterbedingungen anpassen.

**Auflistung der Einzelteile**

| | |
|---|---|
| 1 | Substrat |
| 2 | Schicht |
| 3, 3a | Target |
| 4, 4a | U-förmiges Element |
| 5, 5a | Elektrode |
| 6, 6a | Joch |
| 7, 7a | Dauermagnet |
| 8, 8a | Dauermagnet |
| 9, 9a | Dauermagnet |
| 19, 10a | Gleichstromquelle |
| 11, 11a | Induktivität |
| 12, 12a | Induktivität |
| 13, 13a | Sputtergraben (Gebiet) |
| 14, 14a | Sputtergraben (Gebiet) |
| 15, 15a | Raum, Beschichtungskammer |
| 16 | Gasbehälter |
| 17 | Gasbehälter |
| 18 | Ventil |
| 19 | Ventil |
| 20 | Einlaßstutzen |
| 21 | Einlaßstutzen |
| 22 | Gaszuführungsleitung |
| 23 | Gaszuführungsleitung |
| 24 | Behälter |
| 25 | Behälter, Prozeßkammer |
| 26 | Blende |
| 27, 27a | Elektrischer Anschluß (Masse-Leitung) |
| 28, 28a | elektrischer Anschluß |
| 29, 29a | Kondensator |
| 30, 30a | Kondensator |
| 31, 31a | Dichtring, Haltekragen |

**Patentansprüche**

1. Vorrichtung zum Beschichten eines Substrats (1) mit Werkstoffen, beispielsweise mit einem Metall, bestehend aus Stromquellen (10, 10a), welche mit in einer evakuierbaren Beschichtungskammer (15, 15a) angeordneten Elektroden (5, 5a) verbunden sind, die elektrisch mit Targets (3, 3a) in Verbindung stehen, die zerstäubt werden und deren zerstäubte Teilchen sich auf dem Substrat (1) niederschlagen, wobei in die Beschichtungskammer (15, 15a) ein Prozeßgas einbringbar ist, dadurch gekennzeichnet, daß die Targets (3, 3a) aus einem oder mehreren zu zerstäubenden Werkstoffen jeweils in einem Winkel ($\alpha$, $\alpha'$) zur Ebene des Substrats (1) gehalten sind, wobei sich die Hauptwanderungsrichtungen ( I, I') der Teilchenströme der auf das Substrat (1) ausgerichteten Targets (3, 3a) in einem Punkt (S) schneiden.

2. Vorrichtung nach Anspruch 1, dadurch gekennzeichnet, daß eine Vielzahl von Targets (3, 3a, ...) äquidistant auf einem Kreisbogen angeordnet sind, und die einzelnen Targets (3, 3a, ...) jeweils in einem Winkel ($\alpha$, $\alpha'$, ...) zur Ebene des Substrats (1) gehalten sind, wobei sich die Hauptwanderungsrichtungen der Teilchenströme der auf das Substrat ausgerichteten Targets in einem Punkte (S) schneiden.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-A-2 913 724 (VARIAN ASSOCIATES) <br> * Seite 43, Zeile 22 - Seite 44, Zeile 14; Anspruch 39; Abbildung 6 * <br> — — — | 1,2 | C 23 C 14/35 <br> H 01 J 37/34 |
| X | DE-A-3 409 342 (SATIS VACUUM) <br> * Ansprüche 8,9; Abbildung 1 * <br> — — — | 1,2 | |
| A | EP-A-0 347 567 (LEYBOLD AG) <br> — — — — — | 1,2 | |
| | | | **RECHERCHIERTE SACHGEBIETE (Int. Cl.5)** <br><br> C 23 C |

Der vorliegende Recherchenbericht wurde für alle Patentansprüche erstellt

| Recherchenort | Abschlußdatum der Recherche | Prüfer |
|---|---|---|
| Den Haag | 05 Juli 91 | PATTERSON A.M. |